# EUROPÄISCHE PATENTSCHRIFT

(11) **EP 3 026 699 B1**
(45) Veröffentlichungstag und Bekanntmachung des Hinweises auf die Patenterteilung: **18.01.2023**
(21) Anmeldenummer: 15003347.0
(22) Anmeldetag: 24.11.2015
(51) Int. Cl.: H01L 21/677, F27B 9/24

(54) **ANLAGE ZUM BEHANDELN EINES GUTS**
INSTALLATION FOR THE TREATMENT OF A MATERIAL
INSTALLATION DE TRAITEMENT D'UN PRODUIT

(30) Priorität: 26.11.2014 DE 102014017451
(43) Veröffentlichungstag der Anmeldung: 01.06.2016
(73) Patentinhaber: ONEJOON GmbH, 37120 Bovenden (DE)
(72) Erfinder: Meyer, Wilhelm, D-52385 Nideggen (DE)
(74) Vertreter: Ostertag & Partner Patentanwälte mbB

(56) Entgegenhaltungen:
- JP-A- 2006 237 161
- US-A- 2 497 154
- US-A- 2 932 497
- US-A- 3 026 099

## Beschreibung

Die Erfindung betrifft eine Anlage zum Behandeln eines Guts mit
a) einem Behandlungsraum, der mit einer Hülle ausgestattet ist, welche eine innerhalb der Hülle vorliegende Atmosphäre von einer außerhalb der Hülle vorliegenden Atmosphäre trennt, wobei die innerhalb der Hülle vorliegende Atmosphäre eine kontrollierte Atmosphäre ist;
b) einem Gehäuse, welches den Behandlungsraum begrenzt;
c) mindestens einer zumindest teilweise innerhalb des Behandlungsraums angeordneten Tragrolle zum Fördern des Guts;
d) einer oder mehreren Lagereinrichtungen, welche außerhalb des Gehäuses angeordnet sind und mittels welchen die mindestens eine Tragrolle gelagert ist.

Aus der DE 10 2009 019 127 A1 ist ein Ofen zur Herstellung von photovoltaischen Dünnschichtzellen bekannt, mit einem Ofengehäuse, dessen Wand eine Isolierschicht umfasst, mit einer das Ofengehäuse umgebenden gasdichten Hülle, in deren Innenraum eine kontrollierte Atmosphäre vorliegt, und mit einem eine Vielzahl von Tragrollen umfassenden Fördersystem, mit dem Substratplatten durch das Ofengehäuse förderbar sind, wobei die mit der Antriebseinrichtung verbundenen Endbereiche der Tragrollen in einer Lagereinrichtung gelagert sind, welche Lagereinrichtung mindestens einen Lagerbock umfasst, der durch ein Profilblech getragen wird, welches auf einer Strebe eines mit dem Ofengehäuse verbundenen Stahlbaus steht.

Die in der DE 10 2011 116 136 A1 beschriebene Anlage zur Behandlung von Werkstücken, insbesondere zur Behandlung von Substraten für photovoltaische Dünnschichtzellen, hat ein Gehäuse, welches einen Behandlungsraum begrenzt, in dem eine kontrollierte Atmosphäre vorliegt, wobei Werkstücke durch ein Fördersystem mit einer Vielzahl von Tragrollen durch den Behandlungsraum förderbar sind, wobei die Tragrollen außen an der Seitenwand des Gehäuses gelagert sind.

Die Druckschrift JP2006 237 161 A beschreibt eine Vakuumabscheidevorrichtung mit einem Behandlungsraum, der vakuumdichte Magnetdurchführungen aufweist.

Bei bekannten Anlagen unterliegen insbesondere die Tragrollen und die Lagereinrichtungen für die Tragrollen einem verhältnismäßig hohen Verschleiß.

Aufgabe der vorliegenden Erfindung ist es, eine Anlage zur Behandeln eines Guts bereitzustellen, die gegenüber dem Stand der Technik, beispielsweise im Hinblick auf Nachteile, die mit dem angesprochenen Verschleiß zusammenhängen, weiterentwickelt ist.

Diese Aufgabe wird durch eine Anlage gemäß Anspruch 1 gelöst, insbesondere dadurch, dass:
e) zwischen mindestens einer Lagereinrichtung und einer der Lagereinrichtung zugeordneten Wand des Gehäuses ein flexibles Ausgleichselement vorgesehen ist;
f) eine mit dem Ausgleichselement verbundene Dichtanordnung vorgesehen ist, welche die mindestens eine Lagereinrichtung von der innerhalb der Hülle vorliegenden Atmosphäre trennt.
g) das Ausgleichselement derart vorgespannt angeordnet ist, dass die Dichtanordnung in Richtung der mindestens einen Lagereinrichtung gepresst wird.

Auf diese Weise wird die thermische Belastung der Lagereinrichtung gemindert und ihre Haltbarkeit erhöht. Ausfallzeiten der Anlage, die durch verschleißbedingte Lagerwechsel entstehen, können erfindungsgemäß reduziert werden. Da auf eine direkte Fixierung der Lagereinrichtung am Gehäuse der Anlage verzichtet werden kann, ermöglicht die erfindungsgemäße Anordnung eine einfachere Montage und Demontage der Transportrollen.

Vorzugsweise kann das Ausgleichselement derart ausgebildet sein, dass die mindestens eine Lagereinrichtung hinsichtlich der Tragfunktion für die Tragrolle von der Wand des Gehäuses entkoppelt ist. Somit kann die Wand des Gehäuses, beispielsweise eine Ofenseitenwand, weniger aufwendig konstruiert und kostengünstiger gefertigt werden, z.B. auf Grund großzügiger Fertigungstoleranzen.

Das Ausgleichselement ist derart vorgespannt angeordnet, dass die Dichtanordnung in Richtung der mindestens einen Lagereinrichtung gepresst wird. Derart wird ein selbstständiges Nachstellen der Dichtanordnung ermöglicht, wodurch Verschleiß und Rundlaufungenauigkeiten ausgeglichen werden können.

In zweckmäßiger Ausgestaltung kann das Gehäuse ein oder mehrere Durchgänge aufweisen, die jeweils einer Lagereinrichtung zugeordnet sind, wobei das Ausgleichselement derart zwischen der mindestens einen Lagereinrichtung und der dieser mindestens einen Lagereinrichtung zugeordneten Wand des Gehäuses angeordnet ist, dass trotz eines bestehenden Versatzes zwischen der Achse der Tragrolle und der Achse des Durchgangs für die Tragrolle durch das Ausgleichselement die Abdichtung gewährleistet ist. Derart können Fluchtungsfehler der Durchgänge des Gehäuses unter Vermittlung des Ausgleichselements kompensiert werden. Somit kann der Verschleiß, insbesondere ein durch eine Schrägstellung der Tragrolle bedingter Verschleiß, reduziert werden.

Vorzugsweise kann die Dichtanordnung ein Aufnahmeelement aufweisen, welches im Wesentlichen in Form einer Scheibe ausgebildet ist, und welches sich im Wesentlichen in einer Ebene senkrecht zur Drehachse der Tragrolle erstreckt. Das Vorsehen eines derart ausgebildeten Aufnahmeelements kann gerade beim Einsatz für eine Anlage, welche für einen Schutzgasbetrieb im Überdruck ausgelegt ist, günstig sein.

Es kann beispielsweise zur Beaufschlagung mit Sperrgas von Vorteil sein, wenn die Dichtanordnung ein Dichtelement aufweist, welches zwischen dem Ausgleichselement und dem Aufnahmeelement der Dichtanordnung angeordnet ist. Dabei kann das Aufnahmeelement mit einer Nut zur Aufnahme des Dichtelements versehen sein.

Eine besonders betriebssichere Anordnung kann bereitgestellt werden, wenn das Aufnahmeelement der Dichtanordnung derart ausgebildet ist, dass es sich bei einer Bewegung der Tragrolle, insbesondere bei einer Drehbewegung der Tragrolle beim Fördern des Guts, in kinematischer Kopplung mit der Tragrolle bewegt.

Mit Vorteil kann das Ausgleichselement im Wesentlichen in Form eines Rohrs ausgebildet sein, in welchem ein Teilbereich der Tragrolle angeordnet ist. Derart wird ein besonders leichter Wechsel der Tragrolle ermöglicht.

In weiter vorteilhafter Ausgestaltung kann das Ausgleichselement ein Wellrohr sein.

Vorzugsweise können die Hülle des Behandlungsraums, das mindestens eine Ausgleichselement und die mindestens eine Dichtanordnung einen atmosphärischen Bereich begrenzen, in dem die kontrollierte Atmosphäre des Hülleninneren vorliegt.

Es kann weiterhin zweckmäßig sein, dass die Hülle, das mindestens eine Ausgleichselement und die mindestens eine Dichtanordnung gasdicht ausgebildet sind.

Vorzugsweise kann zumindest ein überwiegender Teil des Ausgleichselements außerhalb des Gehäuses angeordnet sein. Vorteilhaft ist hierbei insbesondere, dass sowohl das Ausgleichselement als auch die Dichtanordnung leicht auf Zustand und Funktion kontrolliert werden können.

Beispielsweise bei beengten Raumvorgaben kann es zweckmäßig sein, wenn zumindest ein Teil des Ausgleichselements in einem Durchgang des Gehäuses angeordnet ist. Derart kann eine besonders kompakte Ausführungsform der Anlage ermöglicht werden.

In weiterer Ausgestaltung weist die Tragrolle einen Rollenkörper und eine Rollenachse auf, wobei der Rollenkörper und die Rollenachse formschlüssig miteinander verbunden sind. Auf diese Weise kann die Wartungsfreundlichkeit der Anlage verbessert werden. Ein Wechsel der Tragrolle wird dabei vereinfacht.

Vorzugsweise erstreckt sich die Tragrolle senkrecht zu zwei Seitenwänden des Gehäuses, wobei jenseits der zwei Seitenwände und von den zwei Seitenwänden beabstandet angeordnet jeweils eine Lagereinrichtung mit einem zugehörigen Ausgleichselement und einer zugehörigen Dichtanordnung vorgesehen ist, wobei die Tragrolle in den beiden Lagereinrichtungen gelagert ist. Derart werden beide Lagereinrichtungen thermisch weniger belastet. Die Lebensdauer der Lagereinrichtungen wird erhöht. Weiterhin kann beispielsweise vermieden werden, dass die häufig mit Lagerfett versehenen Lager der Lagereinrichtungen in Kontakt mit einer Atmosphäre kommen, die vergleichsweise hohe Temperaturen aufweist.

Weitere vorteilhafte Ausgestaltungen ergeben sich aus der nachfolgenden Beschreibung. Dabei werden Ausführungsbeispiele der Erfindung, ohne hierauf beschränkt zu sein, an Hand der Zeichnungen näher erläutert. Es zeigt, jeweils in vereinfachter, schematischer Darstellung:
- Figur 1: einen vertikalen Schnitt durch eine Anlage zur Behandlung eines Guts mit einem an und für sich bekannten Ofen gemäß dem Stand der Technik;
- Figur 2: einen vertikalen Schnitt durch eine Anlage zur Behandlung eines Guts gemäß einem Beispiel der vorliegenden Erfindung;
- Figur 3: in Detailvergrößerung einen vertikalen Schnitt durch eine Anlage zur Behandlung eines Guts gemäß einem weiteren Beispiel der vorliegenden Erfindung;
- Figur 4: ein weiteres Beispiel der Erfindung in einer Figur 3 entsprechenden Ansicht;
- Figur 5: ein weiteres Beispiel der Erfindung in einer Figur 3 entsprechenden Ansicht;
- Figur 6: ein weiteres Beispiel der Erfindung in einer Figur 3 entsprechenden Ansicht.
- Figur 7: eine Detailvergrößerung einer abgewandelten Dichtanordnung.

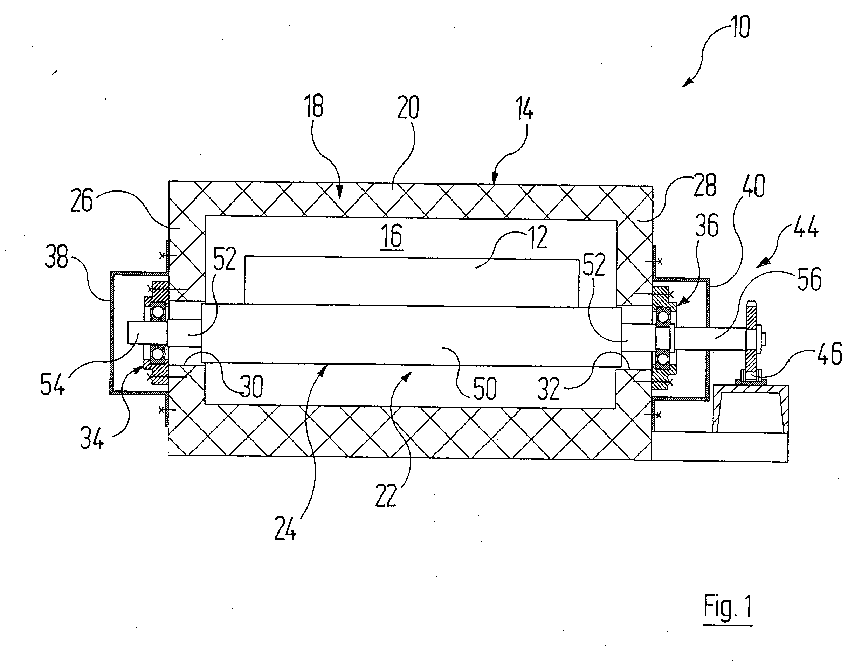

Die Figuren 1 bis 7 zeigen in unterschiedlichen Ausgestaltungen einen insgesamt mit dem Bezugszeichen 10 versehenen Ofen als Beispiel für eine Anlage zur Behandlung eines Guts.

Anlagen zur Behandlung eines Guts können beispielsweise Anlagen zum Härten, Brennen und/oder Sintern, Aufheizen oder Trocknen von Gütern sein. Dabei können Güter beispielsweise Keramiken für die Photovoltaik, technische Keramiken, Elektroden oder elektronische Bauelemente sowie Bleche für das so genannte Hot-Stamping oder Verbundmaterialien sein.

Als Beispiel für ein Gut, welches in einem Behandlungsraum 16 der Anlage behandelt wird, zeigen die Figuren 1 bis 6 ein Werkstück 12, das in den Zeichnungen als Substrat in Form einer Substratplatte für photovoltaische Dünnschichtzellen angedeutet ist. Bei derartigen photovoltaischen Dünnschichtzellen können amorphe Halbleiterschichten zur Anwendung kommen, die weniger als zehn Mikron dick sein können. Die Werkstücke 12, z.B. Substrate für photovoltaische Dünnschichtzellen, können beispielsweise in einem vorzugsweise kontinuierlichen Durchlaufverfahren im Ofen 10 behandelt werden. Aber auch ein getaktet betriebener Ofen ist möglich.

Mittels nicht näher dargestellter Einrichtungen können Substanzen in den Ofen 10 eingebracht oder im Ofen 10 erzeugt werden, die auf die durch den Ofen 10 bewegten Werkstücke 12 aufgebracht werden sollen. In einem Ofen 10 können auch reine thermische Prozesse ohne Materialaufbringung, wie z.B. Glühprozesse, durchgeführt werden.

Anlagen zur Behandlung eines Guts, wie sie in den Figuren 1 bis 6 beispielhaft gezeigt werden, können dann eingesetzt werden, wenn ein Gut in einem Behandlungsraum 16 der Anlage in einer von der Normalatmosphäre abweichenden kontrollierten Atmosphäre behandelt werden soll. Eine derartige kontrollierte Atmosphäre weist Parameter auf, die an physikalisehe und/oder chemische Vorgänge angepasst sind, die in dem Behandlungsraum 16 stattfindenden. Eine kontrollierte Atmosphäre kann z.B. eine Atmosphäre mit gegenüber dem Normaldruck verändertem Druck und/oder eine Atmosphäre mit einem besonderen Gas, insbesondere einem Schutz- oder einem Inertgas, sein. In einer kontrollierten Atmosphäre werden z.B. photovoltaische Zellen hergestellt. In den gezeigten Öfen 10 kann beispielsweise eine Sonderatmosphäre vorliegen mit vergleichsweise hohen Temperaturen, die z.B. über 600°C liegen können.

Zur Erzeugung einer innerhalb des Ofens 10 gewünschten kontrollierten Atmosphäre können die beispielhaft in den Figuren gezeigten Öfen 10 weitere nicht näher dargestellte Einrichtungen aufweisen, wie beispielsweise Vakuumpumpen oder Leitungen, über welche ein Schutzgas zugeführt werden kann.

Die zu behandelnden Werkstücke 12 werden mit Hilfe eines Fördersystems 22 durch den Behandlungsraum 16 bewegt. Die Figuren zeigen beispielhaft jeweils eine als Tragrolle 24 ausgebildete Rolle des Fördersystems 22.

Ein Fördersystem 22 mit einer Tragrolle 24, wie sie in den Figuren 1 bis 6 gezeigt wird, umfasst in der Regel eine Vielzahl von parallel zueinander und in Abstand voneinander angeordneten Tragrollen 24 aus einem geeigneten, temperaturbeständigen Material. Als Material für die Tragrollen 24 kann beispielsweise Keramik, Stahl und/oder Siliziumcarbid, ggf. auch eine Siliziumcarbid-Verbundkeramik, verwendet werden. Ein Durchlaufofen, in dem ein zu beheizendes Gut mittels Tragrollen 24 durch den Ofen 10 bewegt wird, wird auch als Rollenofen bezeichnet.

In den Figuren 1 bis 6 ist jeweils beispielhaft eine Antriebsvorrichtung 44 für die Tragrolle 24 gezeigt, welche mit einer Kette 46 ausgestattet sein kann. Diese Kette 46 kann beispielsweise als durchgezogene Kette ausgebildet sein und in einem Antriebsmechanismus vorgesehen sein, wie er beispielsweise in der DE 693 34 189 T2 beschrieben wird. Die Tragrolle 24 kann auch mit einer anders gearteten, in den Figuren nicht näher dargestellten Antriebsvorrichtung gekoppelt sein. So kann beispielsweise als Antriebsquelle für eine derartige anders geartete Antriebsvorrichtung ein Elektrogetriebemotor vorgesehen sein, wobei der Elektrogetriebemotor unter Zuhilfenahme einer Wellenanordnung mit der Tragrolle 24 gekoppelt ist. Eine derartige Wellenanordnung kann z.B. ähnlich der in der DE 10 2009 019 127 A1 beschriebenen Wellenanordnung ausgestaltet sein, wobei die Wellenanordnung vorzugsweise eine Königswelle aufweisen kann. In weiterhin alternativer Ausgestaltung ist es z.B. möglich, dass ein oder mehrere Tragrollen 24 einer Anlage zur Behandlung eines Guts ohne korrespondierende Antriebsvorrichtung vorgesehen sind. Alternativ oder zusätzlich ist es möglich ein oder mehrere Tragrollen 24 jeweils mit einem Direktantrieb auszustatten.

Fig. 1 zeigt einen insgesamt mit dem Bezugszeichen 10 versehenen Ofen, der nachfolgend als Beispiel für eine an und für sich bekannte Anlage zur Behandlung eines Guts beschrieben wird.

Der Ofen 10 weist ein Gehäuse 14 auf, welches einen Behandlungsraum 16 begrenzt, wobei das Gehäuse 14 eine Schicht mit einem Isoliermaterial 18 und eine gasdichte Hülle 20 umfasst. Im Beispiel ist die Schicht mit dem Isoliermaterial 18 innenseitig der Hülle 20 angeordnet. Als Material für die Isolierschicht kann beispielsweise Mineralwolle eingesetzt werden.

In dem Behandlungsraum 16 der als Ofen ausgebildeten Anlage herrscht die vorangehend angesprochene kontrollierte Atmosphäre. Die kontrollierte Atmosphäre des Behandlungsraums 16 wird durch die gasdichte Hülle 20 von der außerhalb der Hülle 20 vorliegenden Atmosphäre getrennt, wobei die Hülle 20 beispielsweise aus Blech gefertigt sein kann. In den Seitenwänden 26 und 28 des Gehäuses 14 sind Durchgänge 30 bzw. 32 für die Tragrolle 24 vorgesehen.

Die in Fig. 1 gezeigte Tragrolle 24 des Fördersystems 22 weist einen Rollenkörper 50 und eine Rollenachse 52 auf, wobei die Rollenachse 52 durch die Durchgänge 30, 32 in den Seitenwänden 26, 28 des Gehäuses 14 hindurchgeführt ist. Außerhalb des Gehäuses 14 sind an den Seitenwänden 26, 28 beidseitig des Gehäuses 14 Lagereinrichtungen 34 bzw. 36 für die Tragrolle 24 angeordnet. Diese Lagereinrichtungen 34 und 36 sind mit den Seitenwänden 26 bzw. 28 des Gehäuses 14 verbunden und an den Seitenwänden festgelegt. Eine beispielhafte Fixierung der Lagereinrichtungen 34, 46 an den Seitenwänden 26 bzw. 28 ist in Fig. 1 angedeutet.

Die Rollenachse 52 der Tragrolle 24 ist beidseitig in Bereichen, die über die Seitenwände 26, 28 des Gehäuses 14 nach außen vorstehen, in den Lagereinrichtungen 34 und 36 gelagert. Die in den Seitenwänden 26 und 28 angeordneten Durchgänge 30 bzw. 32 für die Tragrolle 24 sind nicht gasdicht ausgeführt. Die Lagereinrichtungen 34, 36 für die Drehachse 52 der Tragrolle 24 sind ebenfalls nicht Gas nicht ausgebildet.

Auf einer ersten Seite des Ofens 14 sind ein erster Endbereich 54 der Drehachse 52 und die zugeordnete Lagereinrichtungen 34 jenseits der Seitenwand 26 von einem Gehäuseteil 38 der Hülle 20 umgeben.

Auf einer zweiten Seite des Ofens 14, welche der ersten Seite gegenüberliegt, ist ein zweiter Endbereich 56 der Drehachse 52 mit der bereits erwähnten Antriebsvorrichtung 44 gekoppelt. Gemäß Fig. 1 sind auf der zweiten Seite des Ofens 10 zumindest ein Teil des zweiten Endbereichs 56 der Drehachse 52 und die zugeordnete Lagereinrichtungen 36 jenseits der Seitenwand 28 von einer Gehäuseteil 40 der Hülle 20 umgeben. Die Gehäuseteile 38, 40 der Hülle 20 sind derart ausgebildet, dass eine möglichst gasdichte Trennung zwischen der Außenatmosphäre und der im Inneren der Hülle 20 herrschenden kontrollierten Atmosphäre bewirkt wird. Ein Teil des zweiten Endbereichs 56 der Drehachse 52 ist in Fig. 1 gezeigten Beispiel aus der Gehäuseteil 40 der Hülle 20 herausgeführt und vorzugsweise endseitig mit der Antriebsvorrichtung 44 verbunden.

Entsprechend der in Fig. 1 gezeigten Anordnung, die an und für sich dem Stand der Technik entspricht, befinden sich die Lagereinrichtungen 34, 36 für die Tragrolle 24 in der im Inneren der Hülle 20 herrschenden kontrollierten Atmosphäre, wobei die Lagereinrichtungen 34, 36 einer hohen thermischen Belastung ausgesetzt sind.

Wie bereits erwähnt sind die Lagereinrichtungen 34 und 36 in dem Stand der Technik entsprechenden Ausführungen eines Ofens 10, wie in der Fig. 1 angedeutet, an den Seitenwänden 26 bzw. 28 des Gehäuses 14 fixiert. Dadurch bedingt kann es auf Grund von in der Praxis nicht immer vermeidbaren Fluchtungsfehlern der Durchgänge 30, 32 in den Seitenwänden 26 bzw. 28 des Gehäuses 14 zu einer unerwünschten Schrägstellung der Tragrolle 24 kommen. Derartige Fluchtungsfehler der Durchgänge 30, 32 können beispielsweise bedingt durch Ungenauigkeiten bei der Ausführung der Ofendurchbrüche auftreten. Eine Schrägstellung der Rolle kann eine ungleichmäßige Rollenabnutzung bedingen und den Verschleiß der Tragrolle 24 bzw. den Verschleiß der Lagereinrichtungen 34 und 36 für die Tragrolle 24 erhöhen.

Der in Fig. 1 gezeigte Ofen 10 ähnelt in seinem Grundaufbau Öfen wie sie beispielsweise die DE 10 2009 019 127 und die DE 10 2011 116 136 A1 beschreiben, wobei auf diese Druckschriften ergänzend Bezug genommen wird.

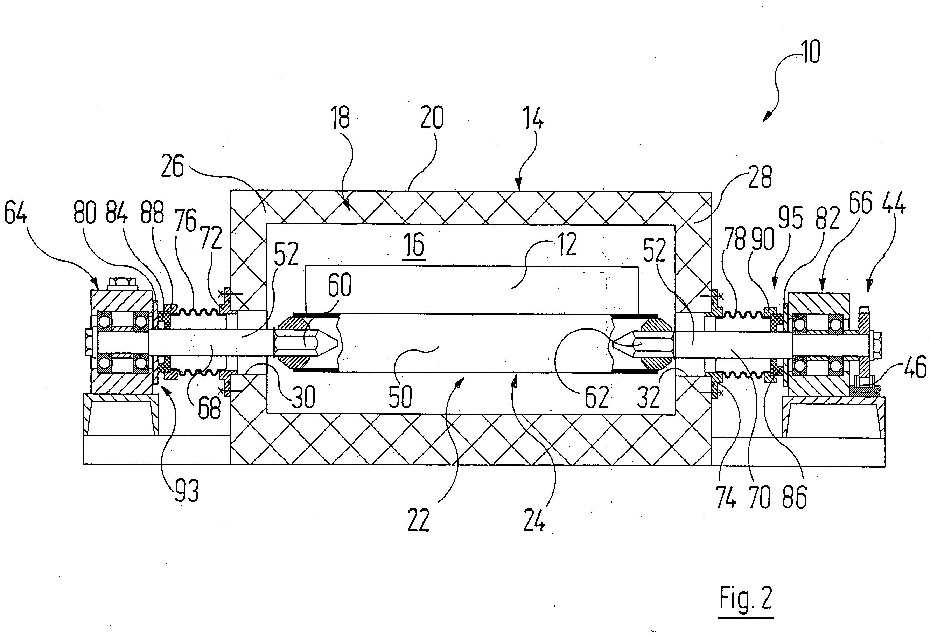

Anhand der Figuren 2 bis 6 werden nachfolgend verschiedene Beispiele der vorliegenden Erfindung beschrieben, wobei ein insgesamt mit dem Bezugszeichen 10 versehener Ofen als Beispiel für eine Anlage zur Behandlung eines Guts beschrieben wird. Dabei wird ein Werkstück 12 in dem von einem Gehäuse 14 umgebenen Behandlungsraum 16 des Ofens 10 behandelt, wobei in dem Ofen 10 insbesondere eine thermische Behandlung erfolgen kann. Das Gehäuse 14 weist gemäß den in den Figuren 2 bis 6 gezeigten Beispielen eine Isolierschicht aus einem Isoliermaterial 18 und eine äußere Hülle 20 auf. Die Hülle 20 des Ofens 10 ist zumindest weitestgehend gasdicht ausgebildet und trennt die kontrollierte Atmosphäre im Behandlungsraum 16 der Anlage von der umgebenden Atmosphäre.

Wie in Fig. 2 angedeutet ist im Behandlungsraum 16 ein Fördersystems 22 mit ein oder mehreren Tragrollen 24 für die zu behandelnden Werkstücke 12 vorgesehen. Die in den Figuren 2 bis 6 gezeigte Tragrolle 24 ist zum Bewegen des Werkstücks 12 durch den Behandlungsraum 16 ausgebildet und mit der bereits erwähnten Antriebsvorrichtung 44 gekoppelt.

Das Gehäuse 14 des Ofens 10 weist mehrere Wände auf. Wände des Gehäuses 14 sind z.B. eine nicht mit Bezugszeichen versehene Decke und die Seitenwände 26, 28.

Außerhalb des Gehäuses 14 sind Lagereinrichtungen 64, 66 für die Tragrolle 24 vorgesehen, wobei die Lagereinrichtungen 64, 66 beabstandet von den Seitenwände 26, 28 des Gehäuses 14 angeordnet sind. Derartige Lagereinrichtungen 64, 66 können beispielsweise als herkömmliche Trag- und Drehlager, z.B. in Form eines Wälzlagers oder Gleitlagers, ausgebildet sein. Die Tragrolle 24 ist in den Lagereinrichtungen 64, 66 gelagert.

Die in den Figuren 2 bis 6 beispielhaft gezeigte Tragrolle 24 weist einen Rollenkörper 50 und eine Rollenachse 52 auf. In den gezeigten Beispielen ragt die Rollenachse 52 über den Rollenkörper 52 hinaus. Der Rollenkörper 50 und die Rollenachse 52 sind vorzugsweise formschlüssig miteinander verbunden. Ein seitlicher Achsabschnitt 70 der Rollenachse 52 erstreckt sich vom Rollenkörper 50 in Richtung der Lagereinrichtung 66.

Fig. 2 zeigt eine Ausgestaltung der Tragrolle 24, bei der die Rollenachse 52 mehrteilig ausgebildet ist, wobei der Rollenkörper 50 zwei Achsabschnitte 68, 70 der Rollenachse 52 verbindet. Im gezeigten Beispiel ist der Rollenkörper 50 auf die Rollenachse 52 gesteckt, wobei die zwei Achsabschnitte 68, 70 mit Polygonwellen 60 bzw. 62 versehen sind. Im gezeigten Beispiel sind die Polygonwellen 60, 62 jeweils als Sechskant ausgebildet. Im gezeigten Beispiel ist der Durchmesser der Rollenachse 52 kleiner als der Durchmesser des Rollenkörpers 50. In einer in den Figuren nicht gezeigten, abweichenden Ausgestaltung der Tragrolle 24 kann der Durchmesser des Rollenkörpers 50 kleiner sein als der Durchmesser der Rollenachse 52. Weitere abweichende Ausgestaltungen des Formschlusses zwischen Rollenachse 52 und Rollenkörper 50 sind möglich.

Gemäß den in den Figuren 2 bis 6 gezeigten Beispielen ist eine der Lagereinrichtung 66 zugewandte Seitenwand 28 des Gehäuses 14 des Ofens 10 mit einem Durchgang 32 für die Tragrolle 24 versehen. Die in Fig. 2 gezeigte Tragrolle 24 erstreckt sich durch Durchgänge 30, 32 des Gehäuses 14 des Ofens 10 hindurch und ist teilweise innerhalb und teilweise außerhalb des Gehäuses 14 angeordnet.

In den Beispielen der Figuren 2 bis 6 ist zwischen der Lagereinrichtung 66 und der Seitenwand 28, welche der Lagereinrichtung 66 zugeordnet ist, ein flexibles Ausgleichselement 78 vorgesehen. Ein Teilbereich der Tragrolle 24 ist in dem Ausgleichselement 78 angeordnet bzw. erstreckt sich durch das vorzugsweise zumindest im Wesentlichen rohrförmig ausgebildete Ausgleichselement 78 hindurch. Derart ist ein leichter Wechsel einzelner Ofenrollen, z.B. der Tragrollen 24 eines Fördersystems 22 (siehe Fig. 2), möglich. Die Rollenabstände in einem Fördersystem 22 können beispielsweise ungefähr gleich oder größer 75 mm sein.

Das Ausgleichselement 78 kann derart vorgespannt angeordnet werden, dass die Dichtanordnung 95 in Richtung der mindestens einen Lagereinrichtung 66 gepresst wird. Auf diese Weise kann ein automatisches Nachstellen mittels des Ausgleichselements 78 derart erfolgen, dass Verschleiß und Rundlaufungenauigkeiten ausgeglichen werden. Dabei kann vorzugsweise die auf die Dichtanordnung 95 wirkende Kraft eingestellt werden. Das flexible Ausgleichselement ist in den Beispielen der Figuren 2 bis 6 als Wellrohr ausgebildet. Durch seine Federwirkung kann das Wellrohr 78 Abnutzungen der Dichtanordnung 95 zumindest teilweise kompensieren. Grundsätzlich kann die Flexibilität des Ausgleichselements 78 bzw. seine Elastizität beispielsweise durch Wahl von Material, Struktur und/oder Geometrie definiert werden.

Weiterhin ist in den Beispielen der Figuren 2 bis 6 eine mit dem Ausgleichselement 78 verbundene Dichtanordnung 95 vorgesehen. Diese Dichtanordnung 95 trennt die Lagereinrichtung 66 von der innerhalb der Hülle 20 bzw. im Gehäuse 14 des Ofens 10 vorliegenden Atmosphäre. Dazu weist die Dichtanordnung 95 vorzugsweise ein Aufnahmeelement auf, welches im Wesentlichen in Form einer Scheibe ausgebildet ist, und welches sich im Wesentlichen in einer Ebene senkrecht zur Drehachse der Tragrolle 24 erstreckt.

Auf der dem Gehäuse 14 zugewandten Seite des beispielsweise als Wellrohr 78 ausgebildeten Ausgleichselements 78 ist ein dichtender Befestigungsflansch 74 vorgesehen, wobei der Befestigungsflansch 74 gemäß Fig. 2 zwischen dem Wellrohr 78 und der Seitenwand 28 angeordnet ist, wobei sich ein Teil des Befestigungsflanschs 74 in den Durchgang 32 erstreckt.

Die in den Beispielen der Figuren 2 bis 6 gezeigten Ausgestaltungen einer Abdichtung der Rollendurchführung sind für einen Ofen 10 im Schutzgasbetrieb mit Überdruck geeignet. Dabei begrenzt die Hülle 20 des Behandlungsraums 16 gemeinsam mit dem Ausgleichselement 78 und der Dichtanordnung 95 und unter Einbeziehung des Befestigungsflanschs 74 bzw. des Dichtelements 96 einen atmosphärischen Bereich, in dem die kontrollierte Atmosphäre des Hülleninneren vorliegt. Die Begrenzungen dieses atmosphärischen Bereichs bzw. die Elemente der Begrenzung sind dabei vorzugsweise gasdicht ausgebildet.

Fig. 2 zeigt eine Dichtanordnung 95 mit einem Dichtelement 86 und mit einer Anlaufscheibe 82 als Aufnahmeelement für das Dichtelement 86. Die Anlaufscheibe 82 ist kinematisch mit der Tragrolle 24 gekoppelt und dreht sich bei einer Drehung der Tragrolle 24 mit dieser mit, wobei die Anlaufscheibe 82 z.B. mit der Rollenachse 52 verschweißt sein kann. Auch das Dichtelement 86 kann ringförmig ausgebildet sein und reibt bei einer Bewegung der Tragrolle 24 an der Anlaufscheibe 82 und an der Rollenachse 52. Das Dichtelement 86 ist zwischen der Anlaufscheibe 82 und dem Wellrohr 78 angeordnet, wobei ein Endbereich des Wellrohrs 78 und ein Teil des Dichtelements 86 von einem Ringelement 90 der Dichtanordnung 95 umfasst sind.

Fig. 2 zeigt schematisch und beispielhaft einen Ofen 10, bei dem jenseits der zwei Seitenwände 26, 28 des Ofens 10 jeweils eine Lagereinrichtung 64, 66 außerhalb des Gehäuses 14 und mit einem Abstand zu den Seitenwänden 26, 28 angeordnet ist. Dabei ist auf beiden Seiten des Gehäuses 14 ein beispielsweise als Wellrohr ausgebildetes Ausgleichselement 76, 78 und eine mit dem Ausgleichselement 76, 78 verbundene Dichtanordnung 93, 95 vorgesehen. Jeweils ein Teilbereich der Achsabschnitte 68, 70 der Rollenachse 52 der Tragrolle 24 erstreckt sich durch das auf der entsprechenden Gehäuseseite vorgesehene Wellrohr 76 bzw. 78. Beidseitig des Gehäuses 14 ist zwischen dem jeweiligen Wellrohr 76, 78 und dem entsprechenden Durchgang 30, 32 der Seitenwand 26, 28 eine vorzugsweise gasdichte Abdichtung vorgesehen, die beispielsweise als Befestigungsflansch 72 bzw. 74 ausgebildet sein kann. Beidseitig weist die Dichtanordnung 93, 95 gemäß dem in Fig. 2 gezeigten Beispiel eine die jeweils zugeordnete Lagereinrichtung 64, 66 abschirmende Anlaufscheibe 80, 82 auf, welche unter Vermittlung zumindest eines Dichtelements 84, 86 mit dem Wellrohr 76, 78 verbunden ist, wobei weiterhin ein Ringelement 88, 90 vorgesehen ist, welches einen Endbereich des Wellrohrs 76, 78 und zumindest einen Teil des Dichtelements 84, 86 umschließt.

Derart können die Funktionen des Lagerns der Tragrolle 24 und des Abdichtens des Behandlungsraums 16 voneinander getrennt werden, was einen sicheren Betrieb der Anlage, insbesondere bei sehr hohen Temperaturen im Bereich der Durchgänge 30, 32 für die Tragrolle 24 ermöglicht. Die Lagereinrichtungen 64, 66 sind hinsichtlich der Tragfunktion für die Tragrolle 24 vom Gehäuses 14 des Ofens 10 entkoppelt.

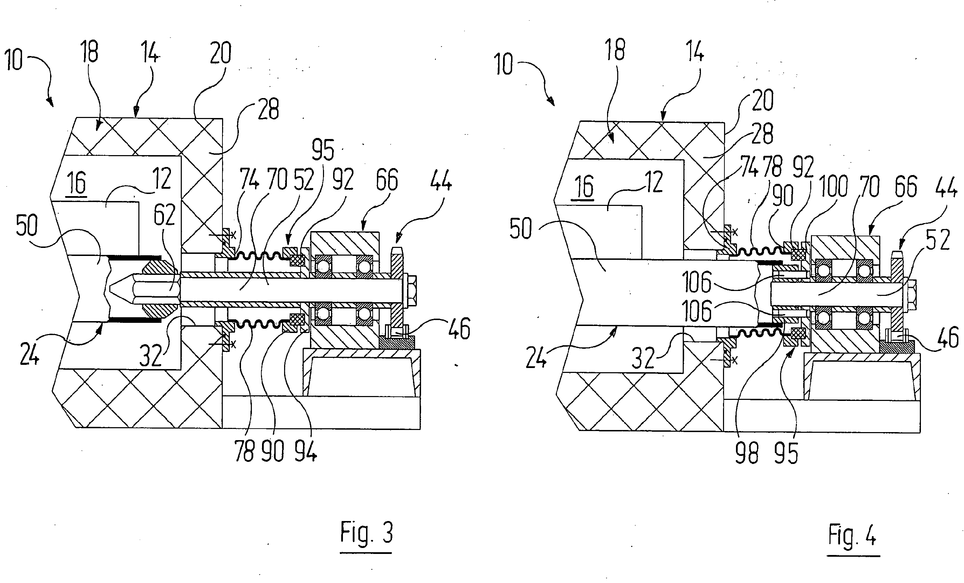

Fig. 3 zeigt einen Ofen 10, bei dem der Rollenkörper 50 der Tragrolle 24 kürzer ist als die Innenbreite des Ofens 10. Die Rollenachse 52 ist zur formschlüssigen Mitnahme über eine Polygonwelle 62 mit dem Rollenkörper 50 verbunden. Die in Fig. 3 gezeigte Dichtanordnung 95 weist eine Anlaufscheibe 94 auf, welche mit einer Nut zur Aufnahme des im gezeigten Beispiel als Dichtring 92 ausgebildeten Dichtelements ausgestattet ist. Die Dichtanordnung 95 weist zudem ein weiteres Ringelement 90 auf, welches radial außerhalb des Dichtrings 92 und des Wellrohrs 78 angeordnet ist. Die Anlaufscheibe 94 kann geklemmt an der Rollenachse 52 angebracht sein, wobei z.B. Scheiben und/oder Hülsen verwendet werden können.

Der Rollenkörper 50 der Tragrolle 24 des in Fig. 4 gezeigten Ofens 10 ist länger als die Innenbreite des Ofens 10. Dabei ragt der Rollenkörper 50 in das im Beispiel als Wellrohr ausgebildete Ausgleichselement 78. Die in Fig. 4 gezeigte Anlaufscheibe 100 der Dichtanordnung 95 weist mehrere Mitnehmerstifte 106 auf, welche in die Tragrolle 24 ragen. Dazu kann beispielsweise der Boden 98 des Rollenkörpers 50 mit Bohrungen zur Aufnahme der Mitnehmerstifte 106 versehen sein. Die Anlaufscheibe 100 weist weiter eine Nut zur Aufnahme des Dichtrings 92 der Dichtanordnung 95 auf, wobei ein weiteres Ringelement 90 vorgesehen ist, welches einen Teil des Dichtrings 92 und einen Teil des Wellrohrs 78 umfasst.

In Fig. 4 ist ein Versatz zwischen der Achse der Tragrolle und der Achse des in der Seitenwand 28 vorgesehenen Durchgangs 32 für die Tragrolle 24 erkennbar. Dieser Versatz kann durch das Ausgleichselement 78 kompensiert werden. Entsprechend ist das Wellrohr 78 im gezeigten Beispiel abweichend von einer horizontalen Achse ausgerichtet, wobei das Wellrohr 78 von der Wand des Gehäuses 14 zur Lagereinrichtung 66 hin aufsteigend ausgerichtet ist. Durch die flexible Ausrichtung des als Wellrohr ausgebildeten Ausgleichselements 78 wird trotz eines bestehenden Versatzes zwischen der Achse der Tragrolle 24 und der Achse des Durchgangs 32 die Abdichtung gewährleistet.

Gemäß den in den Figuren 2 bis 4 gezeigten Beispielen ist das Ausgleichselement 78 außerhalb des Gehäuses 14 angeordnet. Dabei ist der zwischen dem Wellrohr 78 und der Seitenwand 28 vorgesehene Befestigungsflansch 74 vorzugsweise größtenteils außerhalb des Durchgangs 32 angeordnet.

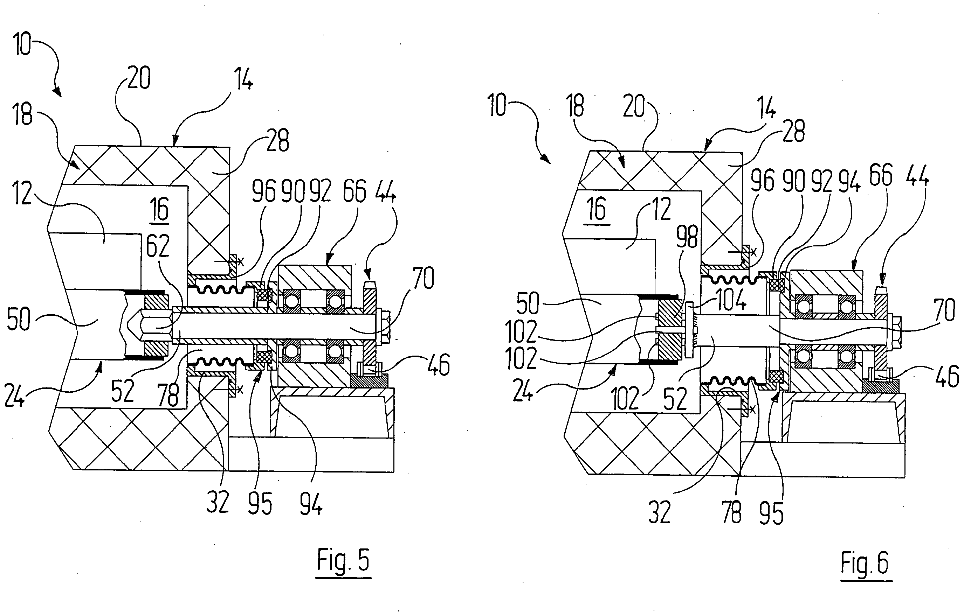

Gemäß den in den Figuren 5 und 6 gezeigten Beispielen ist zumindest ein Teil des Ausgleichselements 78 im Durchgang 32 des Gehäuses 14 angeordnet. Derart wird eine Kompaktere Bauform der die Tragrolle 24 umfassenden Anordnung ermöglicht. In den beiden gezeigten Beispielen ist dabei ein Dichtelement 96 an der Seitenwand 28 vorgesehen, welches zwischen dem als Wellrohr 78 ausgebildete Ausgleichselement 78 und der Seitenwand 28 angeordnet ist, wobei das Dichtelement 96 in den Durchgang 32 der Seitenwand 28 hineingezogen ist bzw. vorzugsweise zu einem wesentlichen Teil innerhalb des Durchgangs 32 angeordnet ist.

Die in den Figuren 5 und 6 gezeigten Dichtanordnungen 95 weisen, ähnlich den bereits vorangehend beschriebenen Dichtanordnungen 95, einen Dichtring 92, ein äußeres Ringelement und eine Anlaufscheibe 94 mit einer Nut zur Aufnahme des Dichtrings 92 auf. Gemäß Fig. 5 ist die Rollenachse 52 der Tragrolle 24 mittels einer Polygonwelle 62 formschlüssig mit dem Rollenkörper 54 verbunden.

Gemäß Fig. 6 ist die Rollenachse 52 der Tragrolle 24 mit einem Kragen 104 versehen. Dabei ist die Rollenachse über beispielsweise am Kragen 104 angeordnete Mitnehmer 102 mit dem Rollenkörper 54 verbunden. Die Mitnehmer 102 sind im gezeigten Beispiel stiftförmig ausgebildet und ragen in den Boden 98 des Rollenkörpers 54. Eine derartige Ausgestaltung kann insbesondere für große Rollen von Vorteil sein. Der Durchmesser des Durchgangs 32 bzw. der Durchmesser des Wellrohrs 78 sind dabei in der Regel auf die Größe der verwendeten Tragrolle 24 abgestimmt.

Die anhand der Figuren 2 bis 6 erläuterten beispielhaften Ausgestaltungen der Erfindung sind für eine Anlage mit sehr hohen Temperaturen im Behandlungsraum 16 geeignet, wobei Materialwahl und Ausführung an die spezifischen Einsatzbedingungen angepasst werden können. Einer der Vorteile dieser Ausgestaltungen liegt darin, dass insbesondere die für den Betrieb wesentlichen Abdichtflächen leichter zugänglich angeordnet sind und somit verhältnismäßig einfach auf Zustand und Funktion kontrolliert werden können. Ein weiterer Vorteil liegt darin, dass die Lager der Lagereinrichtungen 64, 66 besser vor den genannten hohen Temperaturen geschützt sind.

Ein Gedanke, welcher der Erfindung zugrunde liegt, lässt sich wie folgt zusammenfassen: Die vorliegende Erfindung betrifft eine beispielsweise als Rollenofen ausgebildete Anlage zum Behandeln eines Guts, mit einem Behandlungsraum 16, der mit einer Hülle 20 ausgestattet ist, welche eine in ihrem Inneren vorliegende Atmosphäre von einer außerhalb der Hülle 20 vorliegenden Atmosphäre trennt, wobei die innerhalb der Hülle 20 vorliegende Atmosphäre eine kontrollierte Atmosphäre ist, mit einem Gehäuse 14, welches Wände aufweist und den Behandlungsraum 16 begrenzt, mit mindestens einer zumindest teilweise innerhalb des Behandlungsraums 16 angeordneten Tragrolle 24 zum Fördern des Guts, und mit einer oder mehreren Lagereinrichtungen 64, 66, welche außerhalb der Wände des Gehäuses 14 angeordnet sind, und in welchen die mindestens eine Tragrolle 24 gelagert ist, wobei zwischen mindestens einer Lagereinrichtung 64, 66 und einer ihr zugeordneten Wand des Gehäuses 14 ein flexibles Ausgleichselement 78 vorgesehen ist, wobei eine mit dem Ausgleichselement 78 verbundene Dichtanordnung 93, 95 vorgesehen ist, welche die mindestens eine Lagereinrichtung 64, 66 von der innerhalb der Hülle 20 vorliegenden Atmosphäre trennt. Derart kann die Belastung der Lagereinrichtungen 64, 66 gemindert und ihre Lebensdauer erhöht werden.

Durch Verzicht auf eine Fixierung der Lagereinrichtungen 64, 66 am Gehäuse 14 der Anlage kann eine vereinfachte Montage und Demontage der Transportrollen 24 ermöglicht werden. Verschleißbedingte Ausfallzeiten der Anlage werden somit reduziert.

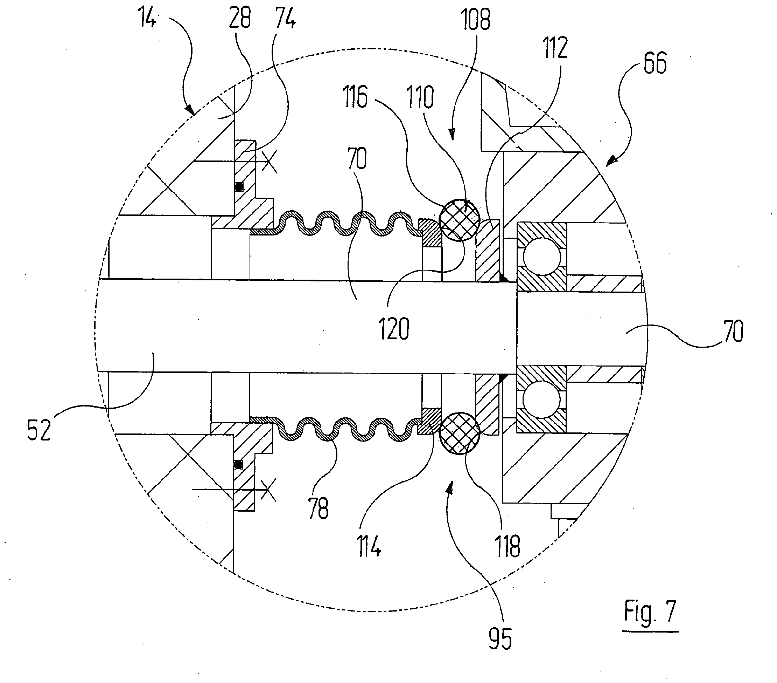

In Figur 7 ist in einer Detailvergrößerung eine abgewandelte Dichtanordnung 95 gezeigt, wobei bereits erläuterte Komponenten dieselben Bezugzeichen tragen.

Dort ist die Dichtanordnung 95 als schwimmende Dichtung 108 ausgebildet, bei der ein Dichtring 110 schwimmend zwischen einer Anlaufscheibe 112 an der Lagereinrichtung 66 und einem Ringelement 114 an dem Ausgleichselement 78 angeordnet ist.

Der Dichtring 110 hat beim vorliegenden Ausführungsbeispiel einen kreisrunden Querschnitt und seine Außenmantelfläche 116 liegt dichtend an einer Dichtfläche 118 der Anlaufscheibe 112 und an einer Dichtfläche 120 des Ringelements 114 an. Hierzu sind diese Dichtflächen 118 und 120 gekrümmt und haben beim vorliegenden Ausführungsbeispiel im Querschnitt einen kreisbogenförmigen Verlauf.

Durch den schwimmend gelagerten Dichtring 110 ist sichergestellt, dass die Dichtung auch bei einer Lageveränderung des Ausgleichselements 78 aufrechterhalten bleibt, da die beteiligten Komponenten einer Lagerveränderung folgen können, ohne dass der durch die gekrümmten Flächen 112, 118, 120 linienhafte Dichtkontakt unterbrochen wird.

Bei einer nicht eigens gezeigten Abwandlung kann der Dichtring 110 auch einen von einem Kreis abweichenden Querschnitt, insbesondere einen rechteckigen oder quadratischen Querschnitt haben. Auf Grund der gekrümmten Gegenflächen 118, 120 ist auch dann stets ein dichtender Kontakt zu der Anlaufscheibe 112 und dem Ringelement 114 gewährleistet.

## Patentansprüche

1. Anlage zum Behandeln eines Guts mit
a) einem Behandlungsraum (16), der mit einer Hülle (20) ausgestattet ist, welche eine innerhalb der Hülle (20) vorliegende Atmosphäre von einer außerhalb der Hülle (20) vorliegenden Atmosphäre trennt, wobei die innerhalb der Hülle (20) vorliegende Atmosphäre eine kontrollierte Atmosphäre ist;
b) einem Gehäuse (14), welches den Behandlungsraum (16) begrenzt;
c) mindestens einer zumindest teilweise innerhalb des Behandlungsraums (16) angeordneten Tragrolle (24) zum Fördern des Guts;
d) einer oder mehreren Lagereinrichtungen (34, 36; 64, 66), welche außerhalb des Gehäuses (14) angeordnet sind und mittels welchen die mindestens eine Tragrolle (24) gelagert ist;
**dadurch gekennzeichnet, dass**
e) zwischen mindestens einer Lagereinrichtung (64, 66) und einer der Lagereinrichtung (64, 66) zugeordneten Wand des Gehäuses (14) ein flexibles Ausgleichselement (76, 78) vorgesehen ist;
f) eine mit dem Ausgleichselement (76, 78) verbundene Dichtanordnung (93, 95) vorgesehen ist, welche die mindestens eine Lagereinrichtung (64, 66) von der innerhalb der Hülle (20) vorliegenden Atmosphäre trennt;
g) das Ausgleichselement (76, 78) derart vorgespannt angeordnet ist, dass die Dichtanordnung (93, 95) in Richtung der mindestens einen Lagereinrichtung (64, 66) gepresst wird.

2. Anlage nach Anspruch 1, **dadurch gekennzeichnet, dass** das Ausgleichselement (76, 78) derart ausgebildet ist, dass die mindestens eine Lagereinrichtung (64, 66) hinsichtlich der Tragfunktion für die Tragrolle (24) von der Wand des Gehäuses (14) entkoppelt ist.

3. Anlage nach einem der Ansprüche 1 bis 2, **dadurch gekennzeichnet, dass** das Gehäuse (14) ein oder mehrere Durchgänge (30, 32) aufweist, die jeweils einer Lagereinrichtung (64 bzw. 66) zugeordnet sind, wobei das Ausgleichselement (76, 78) derart zwischen der mindestens einen Lagereinrichtung (64, 66) und der dieser mindestens einen Lagereinrichtung (64, 66) zugeordneten Wand des Gehäuses (14) angeordnet ist, dass trotz eines bestehenden Versatzes zwischen der Achse der Tragrolle (24) und der Achse des Durchgangs (30 bzw. 32) für die Tragrolle (24) durch das Ausgleichselement (76, 78) die Abdichtung gewährleistet ist.

4. Anlage nach einem der Ansprüche 1 bis 3, **dadurch gekennzeichnet, dass** die Dichtanordnung (93, 95) ein Aufnahmeelement aufweist, welches im Wesentlichen in Form einer Scheibe ausgebildet ist, und welches sich im Wesentlichen in einer Ebene senkrecht zur Drehachse der Tragrolle (24) erstreckt.

5. Anlage nach einem der Ansprüche 1 bis 4, **dadurch gekennzeichnet, dass** die Dichtanordnung (95) ein Dichtelement (92) aufweist, welches Dichtelement (92) zwischen dem Ausgleichselement (76, 78) und dem Aufnahmeelement der Dichtanordnung (95) angeordnet ist.

6. Anlage nach Anspruch 4 oder 5, **dadurch gekennzeichnet, dass** das Aufnahmeelement der Dichtanordnung (93, 95) derart ausgebildet ist, dass es sich bei einer Bewegung der Tragrolle (24), insbesondere bei einer Drehbewegung der Tragrolle (24) beim Fördern des Guts, in kinematischer Kopplung mit der Tragrolle (24) bewegt.

7. Anlage nach einem der Ansprüche 1 bis 6, **dadurch gekennzeichnet, dass** das Ausgleichselement (76, 78) im Wesentlichen in Form eines Rohrs ausgebildet ist, in welchem ein Teilbereich der Tragrolle (24) angeordnet ist.

8. Anlage nach Anspruch 7, **dadurch gekennzeichnet, dass** das Ausgleichselement (76, 78) ein Wellrohr (76, 78) ist.

9. Anlage nach einem der Ansprüche 1 bis 8, **dadurch gekennzeichnet, dass** die Hülle (20) des Behandlungsraums (16), das mindestens eine Ausgleichselement (76, 78) und die mindestens eine Dichtanordnung (93, 95) einen atmosphärischen Bereich begrenzen, in dem die kontrollierte Atmosphäre des Hülleninneren vorliegt.

10. Anlage nach Anspruch 9, **dadurch gekennzeichnet, dass** die Hülle (20), das mindestens eine Ausgleichselement (76, 78) und die mindestens eine Dichtanordnung (93, 95) gasdicht ausgebildet sind.

11. Anlage nach einem der Ansprüche 1 bis 10, **dadurch gekennzeichnet, dass** zumindest ein überwiegender Teil des Ausgleichselements (76, 78) außerhalb des Gehäuses (14) angeordnet ist.

12. Anlage nach einem der Ansprüche 1 bis 11, **dadurch gekennzeichnet, dass** zumindest ein Teil des Ausgleichselements (76, 78) in einem Durchgang (30, 32) des Gehäuses (14) angeordnet ist.

13. Anlage nach einem der Ansprüche 1 bis 12, **dadurch gekennzeichnet, dass** die Tragrolle (24) einen Rollenkörper (50) und eine Rollenachse (52) aufweist, wobei der Rollenkörper (50) und die Rollenachse (52) formschlüssig miteinander verbunden sind.

14. Anlage nach einem der Ansprüche 1 bis 13, **dadurch gekennzeichnet, dass** die Tragrolle (24) sich senkrecht zu zwei Seitenwänden (26 und 28) des Gehäuses (14) erstreckt, wobei jenseits der zwei Seitenwände (26, 28) und von den zwei Seitenwänden (26, 28) beabstandet angeordnet jeweils eine Lagereinrichtung (64 bzw. 66) mit einem zugehörigen Ausgleichselement (76, 78) und einer zugehörigen Dichtanordnung (93, 95) vorgesehen ist, wobei die Tragrolle (24) in den beiden Lagereinrichtungen (64 und 66) gelagert ist.

## Claims

1. Installation for treating a material, said installation having:
a) a treatment chamber (16) which is equipped with an envelope (20) which separates an atmosphere which is present inside the envelope (20) from an atmosphere which is present outside said envelope (20), the atmosphere which is present inside the envelope (20) being a controlled atmosphere;
b) a housing (14) which delimits the treatment chamber (16);
c) at least one supporting roller (24), which is arranged at least partly inside the treatment chamber (16), for conveying the material;
d) one or more mounting apparatuses (34, 36; 64, 66) which are arranged outside the housing (14) and by means of which the at least one supporting roller (24) is mounted;
**characterised in that**:
e) a flexible compensating element (76, 78) is provided between at least one mounting apparatus (64, 66) and a wall of the housing (14) associated with said mounting apparatus (64, 66);
f) a sealing arrangement (93, 95) connected to the compensating element (76, 78) is provided, which separates the at least one mounting apparatus (64, 66) from the atmosphere which is present inside the envelope (20);
g) the compensating element (76, 78) is arranged in a pretensioned manner in such a way that the sealing arrangement (93, 95) is pressed towards the at least one mounting apparatus (64, 66).

2. Installation according to Claim 1, **characterised in that** the compensating element (76, 78) is constructed in such a way that the at least one mounting apparatus (64, 66) is decoupled from the wall of the housing (14) as regards the supporting function for the supporting roller (24).

3. Installation according to one of Claims 1 to 2, **characterised in that** the housing (14) has one or more passages (30, 32) which are each associated with a mounting apparatus (64 and 66 respectively), the compensating element (76, 78) being arranged in such a way, between the at least one mounting apparatus (64, 66) and that wall of the housing (14) which is associated with the said at least one mounting apparatus (64, 66), that sealing is guaranteed by the compensating element (76, 78) in spite of an offset that exists between the axis of the supporting roller (24) and the axis of the passage (30 or 32) for said supporting roller (24).

4. Installation according to one of Claims 1 to 3, **characterised in that** the sealing arrangement (93, 95) has a receiving element which is constructed substantially in the form of a washer and which extends substantially within a plane perpendicular to the axis of rotation of the supporting roller (24) .

5. Installation according to one of Claims 1 to 4, **characterised in that** the sealing arrangement (95) has a sealing element (92), which sealing element (92) is arranged between the compensating element (76, 78) and the receiving element of the sealing arrangement (95).

6. Installation according to Claim 4 or 5, **characterised in that** the receiving element of the sealing arrangement (93, 95) is constructed in such a way that it moves, during a movement of the supporting roller (24), particularly during a rotational movement of said supporting roller (24) when conveying the material, in kinematic coupling with the supporting roller (24).

7. Installation according to one of Claims 1 to 6, **characterised in that** the compensating element (76, 78) is constructed substantially in the form of a tube within which a partial region of the supporting roller (24) is arranged.

8. Installation according to Claim 7, **characterised in that** the compensating element (76, 78) is a corrugated tube (76, 78).

9. Installation according to one of Claims 1 to 8, **characterised in that** the envelope (20) of the treatment chamber (16), the at least one compensating element (76, 78) and the at least one sealing arrangement (93, 95) delimit an atmospheric region in which the controlled atmosphere of the interior of the envelope is present.

10. Installation according to Claim 9, **characterised in that** the envelope (20), the at least one compensating element (76, 78) and the at least one sealing arrangement (93, 95) are of gas-tight construction.

11. Installation according to one of Claims 1 to 10, **characterised in that** at least a predominant part of the compensating element (76, 78) is arranged outside the housing.

12. Installation according to one of Claims 1 to 11, **characterised in that** at least part of the compensating element (76, 78) is arranged in a passage (30, 32) in the housing (14).

13. Installation according to one of Claims 1 to 12, **characterised in that** the supporting roller (24) has a roller body (50) and a roller spindle (52), said roller body (50) and roller spindle (52) being connected to one another in a form-locking manner.

14. Installation according to one of Claims 1 to 13, **characterised in that** the supporting roller (24) extends perpendicularly to two side walls (26 and 28) of the housing (14), there being arranged, on the far side of the two side walls (26, 28) and at a distance from said two side walls (26, 28) in each case, a mounting apparatus (64 and 66 respectively) having an accompanying compensating element (76, 78) and an accompanying sealing arrangement (93, 95), the supporting roller (24) being mounted in the two mounting apparatuses (64 and 66).

## Revendications

1. Installation de traitement d'un produit avec
a) un espace de traitement (16) qui est équipé d'une enveloppe (20) qui sépare une atmosphère présente au sein de l'enveloppe (20) d'une atmosphère présente à l'extérieur de l'enveloppe (20), dans laquelle l'atmosphère présente au sein de l'enveloppe (20) est une atmosphère contrôlée ;
b) un logement (14) qui limite l'espace de traitement (16) ;
c) au moins un rouleau porteur (24) disposé au moins partiellement au sein de l'espace de traitement (16) pour le transport du produit ;
d) un ou plusieurs dispositifs d'entreposage (34, 36 ; 64, 66) qui sont disposés à l'extérieur du logement (14) et au moyen desquels l'au moins un rouleau porteur (24) est entreposé ;
**caractérisée en ce que**
e) un élément d'équilibrage flexible (76, 78) est prévu entre au moins un dispositif d'entreposage (64, 66) et une paroi du logement (14) associée au dispositif d'entreposage (64, 66) ;
f) un agencement d'étanchéité (93, 95) connecté à l'élément d'équilibrage (76, 78) est prévu, lequel sépare l'au moins un dispositif d'entreposage (64, 66) de l'atmosphère présente au sein de l'enveloppe (20) ;
g) l'élément d'équilibrage (76, 78) est disposé de manière précontrainte de telle sorte que l'agencement d'étanchéité (93, 95) est enfoncé en direction de l'au moins un dispositif d'entreposage (64, 66).

2. Installation selon la revendication 1, **caractérisée en ce que** l'élément d'équilibrage (76, 78) est réalisé de telle sorte que l'au moins un dispositif d'entreposage (64, 66) est découplé de la paroi du logement (14) en ce qui concerne la fonction porteuse pour le rouleau porteur (24).

3. Installation selon une des revendications 1 à 2, **caractérisée en ce que** le logement (14) présente un ou plusieurs passages (30, 32) qui sont chacun associés à un dispositif d'entreposage (64 ou 66), dans laquelle l'élément d'équilibrage (76, 78) est disposé entre l'au moins un dispositif d'entreposage (64, 66) et la paroi du logement (14) associée à cet au moins un dispositif d'entreposage (64, 66) de telle sorte que l'étanchéité est garantie par l'élément d'équilibrage (76, 78) malgré un décalage existant entre l'axe du rouleau porteur (24) et l'axe du passage (30 ou 32) pour le rouleau porteur (24).

4. Installation selon une des revendications 1 à 3, **caractérisée en ce que** l'agencement d'étanchéité (93, 95) présente un élément de réception qui est réalisé essentiellement sous la forme d'un disque et qui s'étend essentiellement dans un plan perpendiculaire à l'axe de rotation du rouleau porteur (24).

5. Installation selon une des revendications 1 à 4, **caractérisée en ce que** l'agencement d'étanchéité (95) présente un élément d'étanchéité (92), lequel élément d'étanchéité (92) est disposé entre l'élément d'équilibrage (76, 78) et l'élément de réception de l'agencement d'étanchéité (95).

6. Installation selon la revendication 4 ou 5, **caractérisée en ce que** l'élément de réception de l'agencement d'étanchéité (93, 95) est réalisé de telle sorte qu'il se déplace lors d'un mouvement du rouleau porteur (24), notamment lors d'un mouvement rotatif du rouleau porteur (24) lors du transport du produit, en couplage cinématique avec le rouleau porteur (24).

7. Installation selon une des revendications 1 à 6, **caractérisée en ce que** l'élément d'équilibrage (76, 78) est réalisé essentiellement sous la forme d'un tube dans lequel une région partielle du rouleau porteur (24) est disposée.

8. Installation selon la revendication 7, **caractérisée en ce que** l'élément d'équilibrage (76, 78) est un tube ondulé (76, 78).

9. Installation selon une des revendications 1 à 8, **caractérisée en ce que** l'enveloppe (20) de l'espace de traitement (16), l'au moins un élément d'équilibrage (76, 78) et l'au moins un agencement d'étanchéité (93, 95) limitent une région atmosphérique dans laquelle l'atmosphère contrôlée de l'intérieur de l'enveloppe est présente.

10. Installation selon la revendication 9, **caractérisée en ce que** l'enveloppe (20), l'au moins un élément d'équilibrage (76, 78) et l'au moins un agencement d'étanchéité (93, 95) sont réalisés de manière étanche au gaz.

11. Installation selon une des revendications 1 à 10, **caractérisée en ce qu'**au moins une partie prédominante de l'élément d'équilibrage (76, 78) est disposée à l'extérieur du logement (14).

12. Installation selon une des revendications 1 à 11, **caractérisée en ce qu'**au moins une partie de l'élément d'équilibrage (76, 78) est disposée dans un passage (30, 32) du logement (14).

13. Installation selon une des revendications 1 à 12, **caractérisée en ce que** le rouleau porteur (24) présente un corps de rouleau (50) et un axe de rouleau (52), dans laquelle le corps de rouleau (50) et l'axe de rouleau (52) sont connectés l'un à l'autre par conjugaison de formes.

14. Installation selon une des revendications 1 à 13, **caractérisée en ce que** le rouleau porteur (24) s'étend perpendiculairement à deux parois latérales (26 et 28) du logement (14), dans laquelle un dispositif d'entreposage (64 ou 66) avec un élément d'équilibrage associé (76, 78) et un agencement d'étanchéité associé (93, 95) est à chaque fois prévu de l'autre côté des deux parois latérales (26, 28) et disposé à l'écart des deux parois latérales (26, 28), dans laquelle le rouleau porteur (24) est entreposé dans les deux dispositifs d'entreposage (64 et 66).
